# FASCICULE DE BREVET EUROPEEN

(11) **EP 0 333 567 B1**
(45) Date de publication et mention de la délivrance du brevet: **21.04.1993**
(21) Numéro de dépôt: 89400676.6
(22) Date de dépôt: 10.03.1989
(51) Int. Cl.: H01P 1/10

(54) **Interrupteur hyperfréquence**
Mikrowellenschalter
Microwave switch

(30) Priorité: 18.03.1988 FR 8803525
(43) Date de publication de la demande: 20.09.1989
(73) Titulaire: THOMSON-CSF, 75008 Paris (FR)
(72) Inventeur: Cachier, Gérard, F-92045 Paris la Défense (FR)
(74) Mandataire: Benoit, Monique

(56) Documents cités:
- EP-A- 0 047 686
- DE-A- 1 591 528
- US-A- 3 522 492
- US-A- 3 769 618
- PROCEEDINGS OF THE INSTITUTION OF ELECTRICAL ENGINEERS, vol. 115, no. 4, avril 1968, pages 479-486, Stevenage, Herts, GB; D.M. KITCHING et al.: "Narrowband microwave suppression filters"

## Description

L'invention a pour objet un interrupteur hyperfréquence comportant un dispositif d'interférence dont l'une et/ou l'autre branche est susceptible de subir une transition réversible d'un état normal vers un état supraconducteur, la position de l'interrupteur étant fonction de l'état (normal ou supraconducteur) respectif des deux branches. Un tel interrupteur peut être avantageusement appliqué à la réalisation de duplexeurs de systèmes radars, de déphaseurs hyperfréquence et d'atténuateurs hyperfréquence.

Les caractéristiques d'un interrupteur hyperfréquence sont notamment :
- sa fréquence (ou sa longueur d'onde) de fonctionnement ;
- la largeur de la bande passante encadrant la fréquence de fonctionnement ;
- la nature et l'importance des pertes dues à sa présence le long d'une ligne hyperfréquence, cette présence étant susceptible d'introduire une réflexion partielle (mesurée par un T.O.S.), des pertes par rayonnement et/ou thermiques, une déviation partielle de l'énergie transmise le long de la ligne ;
- son temps de commutation entre un état "passant" (correspondant à une fermeture de l'interrupteur) et un état "bloqué" (correspondant à une ouverture de l'interrupteur), et réciproquement ;
- sa tenue en puissance ;
- ses dimensions, sa fiabilité, sa consommation, et son coût de fabrication.

Il est connu d'utiliser une diode PIN (notoirement adaptée aux signaux hyperfréquence) comme interrupteur hyperfréquence : soumise à une polarisation directe, elle se comporte comme un interrupteur passant, et lorsqu'on lui applique une polarisation inverse, elle est analogue à un interrupteur bloqué. Cependant, ainsi qu'il est connu, le temps de commutation d'une telle diode est limité inférieurement par le temps nécessaire à l'évacuation des porteurs minoritaires (qui sont les porteurs contribuant le plus largement au passage d'un courant hyperfréquence lorsque la diode est polarisée dans le sens direct). En outre, une diode PIN montée sur une ligne hyperfréquence, introduit une résistance en série parasite (phénomène connu par l'homme du métier). Enfin, le tenue en puissance d'une telle diode est limitée supérieurement par la valeur de la tension d'avalanche de la diode.

Il est également connu d'utiliser comme interrupteur hyperfréquence un tube dit "TR" (ce qualificatif étant une abréviation de l'épithète anglais "Transmit-Receive", ce type de tube étant en effet fréquemment utilisé au sein d'une antenne radar pour isoler le récepteur à l'émission et empêcher la propagation de signaux vers l'émetteur à la réception). Le temps de commutation de tels tubes est malheureusement limité inférieurement par le temps nécessaire à l'évacuation et/ou à l'élimination d'atomes ionisés et d'électrons. En outre ce phénomène de relaxation, ainsi qu'il est connu, n'est que partiel : l'ionisation résiduelle du gaz contenu dans le tube nuit à la fiabilité dudit interrupteur.

Le document DE-A-1 591 528 décrit un interrupteur hyperfréquence comportant un dispositif d'interférence dont une branche, contenant une ferrite, est susceptible de subir une transition réversible d'un état normal vers un état magnétisé introduisant un déphasage supplémentaire de π pour l'onde la traversant.

L'invention concerne un interrupteur hyperfréquence comportant un tronçon de ligne hyperfréquence se séparant en deux branches de longueurs différentes, ces deux branches se réunissant ensuite en un second tronçon ; la différence de longueur des deux branches est sensiblement égale à un nombre impair de demi-longueurs d'onde de fonctionnement de l'interrupteur ; l'une au moins des deux branches est susceptible de passer de façon réversible et commandée d'un état normal dans un état supraconducteur ; l'interrupteur est ouvert (c'est-à-dire dans l'état bloqué) lorsque les deux branches sont dans le même état, et fermé (c'est-à-dire dans l'état passant) sinon.

L'invention a plus précisément pour objet un interrupteur hyperfréquence comportant :
- un premier tronçon de ligne hyperfréquence,
- une bifurcation du premier tronçon en une première et une seconde branches de ligne hyperfréquence,
- une réunion en un second tronçon de ligne hyperfréquence des deux branches,
- des moyens de déphasage assurant une mise en opposition de phase de signaux transmis sur chacune des deux branches et recombinés au niveau de ladite réunion ,
- des moyens de commande des moyens de déphasage, l'interrupteur étant caractérisé en ce que :
- les moyens de déphasage sont constitués de la première et de la seconde branches, les longueurs respectives de ces deux branches différant d'une quantité sensiblement égale à un nombre impair de demi-longueurs d'onde de fonctionnement de l'interrupteur, l'une au moins des deux branches étant susceptible de passer de façon réversible d'un état normal dans un état supraconducteur à une température critique,
- les moyens de commande régissent l'état de l'une ou de chacune des deux branches, une identité et une différence d'état entre les deux branches assurant respectivement l'ouverture et la fermeture de l'interrupteur, et les impédances de ces branches assurant une division de la puissance en deux parties sensiblement égales à l'endroit de la bifurcation lorsque les deux branches sont dans le même état.

Des précisions, des particularités et des modes de réalisation de l'invention apparaîtront au cours de la description qui suit, à l'aide des figures annexées, qui représentent :
- la figure 1, une vue de dessus partielle d'un interrupteur hyperfréquence selon un mode de réalisation de l'invention ;
- la figure 2, une coupe schématique de l'interrupteur hyperfréquence de la figure 1.

Sur ces deux figures, d'une part l'échelle réelle et les proportions des différents éléments n'ont pas été respectées, et d'autre part les mêmes références se rapportent aux mêmes éléments.

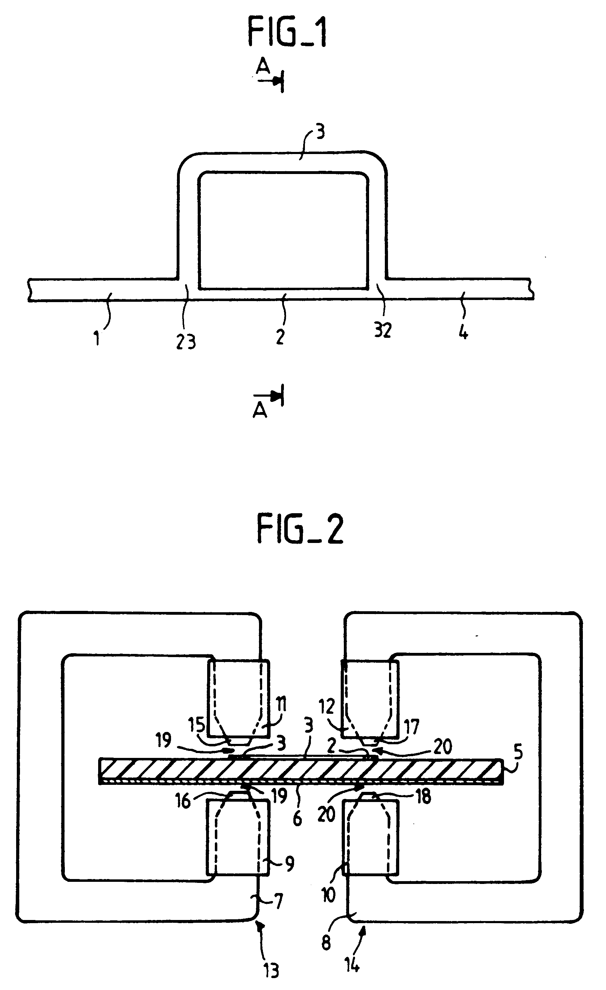

La figure 1 représente une vue de dessus partielle d'un interrupteur, selon un mode de réalisation de l'invention, fabriqué à partir de lignes microrubans 1, 2, 3, et 4 ayant un substrat diélectrique commun (non représenté sur la figure 1) et un plan de masse commun (non représenté sur la figure 1).

Une première ligne microruban 1 (appelée premier tronçon dans ce qui suit) se sépare en deux lignes microruban 2 et 3 (appelées branches 2 et 3 dans ce qui suit) au niveau d'une bifurcation 23 ; les deux branches 2 et 3 se rejoignent au niveau d'une réunion 32 pour reformer une ligne microruban unique 4 (appelée tronçon 4 dans ce qui suit). La longueur de la branche 3 est supérieure à celle de la branche 2 et la différence de longueur entre ces deux branches est sensiblement égale à un nombre impair de demi-longueurs d'onde de fonctionnement de l'interrupteur.

Les conducteurs centraux respectifs des tronçons 1 et 4 et des branches 2 et 3 sont fabriqués dans un même matériau supraconducteur dont la température critique T_{c} (c'est-à-dire la température de transition réversible entre un état "normal" et un état "supraconducteur" dudit matériau) est de préférence supérieure à 30 K ; à titre d'exemple, on connaît des matériaux supraconducteurs dont la température critique T_{c} est comprise entre 30 K et 95 K : ce sont par exemple des oxydes de cuivre. Le fonctionnement de l'interrupteur (exposé dans ce qui suit) ne fait intervenir la supraconductivité que d'une ou des deux branches 2 ou 3, mais les conducteurs centraux des quatre tronçons 1 et 4 ou branches 2 et 3 sont avantageusement réalisés à partir du même matériau pour éviter l'apparition de pertes, notamment par réflexion au niveau de jonctions entre matériaux différents, et pour simplifier la réalisation industrielle de l'interrupteur objet de la présente invention.

Le plan de masse commun (non représenté sur la figure 1) est de préférence réalisé dans le même matériau que les conducteurs centraux, et ce pour plus de commodité lors de la fabrication de l'interrupteur présentement décrit. Le choix du matériau constitutif du plan de masse commun est de toute façon du ressort de l'homme du métier qualifié dans à la fois le domaine des lignes hyperfréquence et dans celui de la supraconductivité.

L'interrupteur présentement décrit est en outre muni de moyens de commande de l'état (normal ou supraconducteur) du matériau constituant le conducteur central de la branche 2 et/ou (selon le mode de fonctionnement désiré, les différents modes de fonctionnement de l'interrupteur étant décrits dans ce qui suit) de celui de la branche 3 ; lorsque l'état de chacune des deux branches 2 et 3 est susceptible d'être commandé, les moyens de commande de l'état de chacune de ces deux branches sont indépendants. Dans le cas où le plan de masse commun est réalisé lui aussi dans un matériau supraconducteur, les mêmes moyens de commande contrôlent l'état (normal ou supraconducteur) de la portion du plan de masse située sensiblement en regard du conducteur central de la branche 2 et/ou (comme cela a été expliqué précédemment) de celui de la branche 3.

Selon un premier mode de fonctionnement de l'interrupteur présentement décrit, on réalise l'ouverture de l'interrupteur (c'est-à-dire on place l'interrupteur dans un état bloqué) en rendant à la fois la branche 2 et la branche 3 supraconductrices (c'est-à-dire en mettant les conducteurs centraux respectifs des branches 2 et 3, et éventuellement les portions du plan de masse commun situées en regard de ces branches, dans un état supraconducteur) : en effet, un signal hyperfréquence se propageant le long du tronçon 1 vers la bifurcation 23 donne naissance à deux signaux, se propageant respectivement le long des branches 2 et 3, qui se retrouvent au niveau de la réunion 32 en opposition de phase ; moyennant une adaptation adéquate des impédances respectives des branches 2 et 3 (une telle adaptation est facilement réalisable par l'homme du métier : elle vise en particulier à obtenir une division de la puissance en deux parties sensiblement égales à l'endroit de la bifurcation (23) ; elle est schématisée sur la figure 1 par le fait que le conducteur central de la ligne 2 est plus étroit que celui de la ligne 3), lesdits deux signaux se retrouvent au niveau de la réunion 32 avec en outre des amplitudes sensiblement égales ; les phases et les amplitudes relatives de ces deux signaux empêchent toute propagation d'un signal le long du tronçon 4 en s'éloignant de la réunion 32 : l'interrupteur est bien ouvert. Pour fermer l'interrupteur (c'est-à-dire pour le placer dans un état passant), on fait passer l'une des branches 2 ou 3, par exemple la branche 2, dans un état normal (en manipulant les moyens de commande mentionnés dans ce qui précède et décrits dans ce qui suit) : la branche 3 ("supraconductrice") court-circuite alors la branche 2 ("normale") ; plus précisément un signal hyperfréquence se propageant le long du tronçon 1 vers la bifurcation 23, passe sensiblement intégralement dans la branche 3, se propage le long de cette branche 3, passe par la réunion 32, puis se propage le long du tronçon 4 en s'éloignant de cette réunion 32 : l'interrupteur est bien fermé.

Selon un second mode de fonctionnement de l'interrupteur présentement décrit, l'interrupteur est ouvert lorsque les branches 2 et 3 sont toutes les deux normales : l'interrupteur se comporte alors sensiblement de la même façon que lorsque les branches 2 et 3 sont chacune supraconductrices (ce qui correspond au premier mode de fonctionnement, précédemment décrit), moyennant une adaptation des impédances respectives des branches 2 et 3 plus importante à cause de pertes plus élevées le long des branches 2 et 3. Pour fermer l'interrupteur, on fait passer l'une des branches 2 ou 3, par exemple la branche 3, dans un état supraconducteur, cette branche 3 court-circuitant alors la branche 2.

La figure 2, qui est une coupe schématique, selon la ligne AA de la figure 1, de l'interrupteur hyperfréquence de cette figure 1, illustre un mode de réalisation des moyens de commande de l'état (normal ou supraconducteur) de la branche 2 et/ou de la branche 3. Ces moyens comportent deux électro-aimants 13 et 14, qui sont indépendants (c'est-à-dire qui sont alimentés indépendamment l'un de l'autre). Ainsi qu'il est connu, l'électro-aimant 13 (respectivement 14) comporte un barreau de fer doux 7 (respectivement 8), recourbé de façon à former une boucle non fermée dont les extrémités 15 et 16 (respectivement 17 et 18), sont entourées respectivement par des bobines 11 et 9 (respectivement 12 et 10), et sont situées autour de la branche 3 (respectivement 2) ; autrement dit, la branche 3 (respectivement 2) est située dans l'entrefer 19 (respectivement 20) de l'électro-aimant 13 (respectivement 14).

Sur cette figure 2 sont en outre représentés le plan de masse commun 6 et le substrat diélectrique commun 5 mentionnés dans la description de la figure 1.

Les électro-aimants 13 et 14 permettent d'appliquer dans la région respectivement des branches 3 et 2 un champ magnétique sensiblement uniforme et susceptible de varier dans le temps, c'est-à-dire non constant ; la variation de ce champ magnétique produit une variation de la température critique T_{c} de chacune des branches 3 et 2. Il est ainsi possible d'abaisser la température critique T_{c} d'une branche donnée en dessous de la température T à laquelle fonctionne l'interrupteur (qui peut par exemple être celle de l'azote liquide) et de rendre ainsi la branche "normale" ; inversement on peut faire monter la température critique T_{c} d'une branche donnée au-dessus de la température T à laquelle se trouve l'interrupteur et rendre ainsi la branche "supraconductrice".

Au lieu de faire varier T_{c} autour de T, comme cela a été expliqué dans le paragraphe précédent, on peut aussi faire varier T autour de T_{c} (ce qui est plus simple du point de vue du concept, mais plus compliqué à réaliser en pratique, ainsi qu'il est connu par l'homme du métier) : ce moyen de commande de l'état (normal ou supraconducteur) de l'une et/ou de l'autre branche rentre dans le cadre de l'invention.

L'invention couvre également un interrupteur analogue à celui décrit dans ce qui précède, mais fabriqué à partir de guides d'ondes, de lignes coaxiales, ou de tout autre type de ligne hyperfréquence à constantes réparties ou à constantes localisées (et non plus à partir de lignes microrubans). Des guides d'ondes comportant des parois intérieures recouvertes d'un matériau supraconducteur sont en effet connus : selon l'état, normal ou supraconducteur, dudit matériau, les guides sont eux aussi dits "normaux" ou "supraconducteurs" vis-à-vis de la propagation d'un signal hyperfréquence. Un tel interrupteur comporte par exemple :
- un premier guide d'ondes (constituant ledit premier tronçon 1) ;
- une première jonction en T parallèle (constituant ladite bifurcation 23) ;
- deux portions de guides d'ondes (constituant respectivement lesdites branches 2 et 3) ;
- une seconde jonction en T parallèle (constituant ladite réunion 32) ;
- un second guide d'onde (constituant ledit second tronçon 4).

Naturellement, l'invention n'est pas limitée aux exemples de réalisation décrits.

## Revendications

1. Interrupteur hyperfréquence comportant :
- un premier tronçon (1) de ligne hyperfréquence,
- une bifurcation (23) du premier tronçon (1) en une première et une seconde branches (2, 3) de ligne hyperfréquence,
- une réunion (32) en un second tronçon (4) de ligne hyperfréquence des deux branches (2, 3),
- des moyens de déphasage (2, 3) assurant une mise en opposition de phase de signaux transmis sur chacune des deux branches et recombinés au niveau de ladite réunion (32) ,
- des moyens de commande (13, 14) des moyens de déphasage (2, 3), l'interrupteur étant caractérisé en ce que :
- les moyens de déphasage (2, 3) sont constitués de la première et de la seconde branches (2, 3), les longueurs respectives de ces deux branches différant d'une quantité sensiblement égale à un nombre impair de demi-longueurs d'onde de fonctionnement de l'interrupteur, l'une au moins des deux branches (2 ; 3 ; 2, 3) étant susceptible de passer de façon réversible d'un état normal dans un état supraconducteur à une température critique (Tc),
- les moyens de commande (13, 14) régissent l'état de l'une ou de chacune des deux branches (2 ; 3 ; 2, 3), une identité et une différence d'état entre les deux branches assurant respectivement l'ouverture et la fermeture de l'interrupteur, et les impédances de ces branches (2, 3) assurant une division de la puissance en deux parties sensiblement égales à l'endroit de la bifurcation (23) lorsque les deux branches sont dans le même état.

2. Interrupteur hyperfréquence selon la revendication 1, caractérisé en ce que les moyens de commande (13, 14) assurent une application d'un champ magnétique variable sur l'une ou sur chacune des deux branches, cette application faisant varier la température critique (Tc) de la ou des branche(s) considérée(s) ce qui assure le passage réversible d'un état normal dans un état supraconducteur de la ou des branche(s) considérée(s) sans variation de la température de celle(s)-ci.

3. Interrupteur hyperfréquence selon la revendication 2, caractérisé en ce que les moyens de commande (13, 14) comportent deux électro-aimants (13, 14) indépendants dont les entrefers respectifs sont situés respectivement autour des deux branches (2, 3).

4. Interrupteur hyperfréquence selon la revendication 1, caractérisé en ce que les moyens de commande assurent une variation de la température de l'une ou de chacune des deux branches, autour de la température critique (T_{c}), sans variation de celle-ci.

5. Interrupteur hyperfréquence selon l'une des revendications précédentes, caractérisé en ce qu'il est ouvert lorsque les deux branches (2, 3) sont dans un état normal.

6. Interrupteur hyperfréquence selon l'une des revendications 1 à 4, caractérisé en ce qu'il est ouvert lorsque les deux branches (2, 3) sont dans un état supraconducteur.

7. Interrupteur hyperfréquence selon l'une des revendications précédentes, caractérisé en ce que lesdits tronçons (1, 4) et branches (2, 3) de lignes hyperfréquence sont des lignes microrubans.

8. Interrupteur hyperfréquence selon l'une des revendications 1 à 6, caractérisé en ce que :
- lesdits tronçons (1, 4) et branches (2, 3) de lignes hyperfréquence sont des guides d'ondes ;
- ladite bifurcation (23) et ladite réunion (32) sont des jonctions en T parallèle.

## Patentansprüche

1. Höchstfrequenzschalter mit:
- einem ersten Höchstfrequenzleitungsabschnitt (1),
- einer Verzweigung (23) des ersten Abschnitts (1) in einen ersten und einen zweiten Höchstfrequenzleitungszweig (2, 3),
- einer Vereinigung (32) der beiden Zweige (2, 3) in einen zweiten Höchstfrequenzleitungsabschnitt (4),
- Phasenverschiebungsmitteln (2, 3), die gewährleisten, daß Signale, die über jeden der beiden Zweige übertragen und auf der Höhe der Vereinigung (32) wiedervereinigt werden, in Gegenphase gebracht werden,
- Steuermitteln (13, 14) für die Phasenverschiebungsmittel (2, 3), wobei der Schalter dadurch gekennzeichnet ist, daß:
- die Phasenverschiebungsmittel (2, 3) aus dem ersten und dem zweiten Zweig (2, 3) gebildet sind, wobei sich die jeweiligen Längen dieser beiden Zweige um einen Betrag unterscheiden, der im wesentlichen gleich einer ungeraden Anzahl von halben Betriebswellenlängen des Schalters ist, wobei wenigstens einer der beiden Zweige (2; 3; 2, 3) in der Lage ist, bei einer kritischen Temperatur (T_{c}) in reversibler Weise von einem normalen Zustand in einen supraleitenden Zustand überzugehen,
- die Steuermittel (13, 14) den Zustand eines oder jedes der beiden Zweige (2; 3; 2, 3) bestimmen, wobei eine Gleichheit bzw. ein Unterschied des Zustands zwischen den beiden Zweigen das Öffnen bzw. das Schließen des Schalters bewirken und wobei die Impedanzen dieser Zweige (2, 3) eine Unterteilung der Leistung in zwei im wesentlichen gleiche Teile an der Stelle der Verzweigung (23) bewirken, wenn die beiden Zweige in dem gleichen Zustand sind.

2. Höchstfrequenzschalter nach Anspruch 1, dadurch gekennzeichnet, daß die Steuermittel (13, 14) das Anlegen eines veränderlichen Magnetfelds an einen oder an jeden der beiden Zweige bewirken, wobei dieses Anlegen die kritische Temperatur (T_{c}) des betreffenden Zweiges oder der betreffenden Zweige verändert, was den reversiblen Übergang von einem normalen Zustand in einen supraleitenden Zustand des betreffenden Zweiges oder der betreffenden Zweige ohne Änderung von deren Temperatur bewirkt.

3. Höchstfrequenzschalter nach Anspruch 2, dadurch gekennzeichnet, daß die Steuermittel (13, 14) zwei unabhängige Elektromagnete (13, 14) enthalten, deren jeweilige Luftspalte die beiden Zweige (2, 3) umgeben.

4. Höchstfrequenzschalter nach Anspruch 1, dadurch gekennzeichnet, daß die Steuermittel (13, 14) eine Änderung der Temperatur eines oder jedes der beiden Zweige um die kritische Temperatur (T_{c}) ohne deren Änderung bewirken.

5. Höchstfrequenzschalter nach einem der vorhergehenden Ansprüche, dadurch gekennzeichnet, daß er geöffnet ist, wenn die beiden Zweige (2, 3) in einem normalen Zustand sind.

6. Höchstfrequenzschalter nach einem der Ansprüche 1 bis 4, dadurch gekennzeichnet, daß er geöffnet ist, wenn die beiden Zweige (2, 3) in einem supraleitenden Zustand sind.

7. Höchstfrequenzschalter nach einem der vorhergehenden Ansprüche, dadurch gekennzeichnet, daß die Höchstfrequenzleitungsabschnitte (1, 4) und die Höchstfrequenzleitungszweige (2, 3) Mikrobandleitungen sind.

8. Höchstfrequenzschalter nach einem der Ansprüche 1 bis 6, dadurch gekennzeichnet, daß:
- die Höchstfrequenzleitungsabschnitte (1, 4) und die Höchstfrequenzleitungszweige (2, 3) Wellenleiter sind;
- die Verzweigung (23) und die Vereinigung (32) parallele T-Kopplungsstücke sind.

## Claims

1. A radio frequency switch comprising:
- a first section (1) of radio frequency line,
- a branchpoint (23) of the first section (1) into a first and a second branch (2, 3) of radio frequency line,
- a combination (32) of the two branches (2, 3) into a second section (4) of radio frequency line
- phase shift means (2, 3) ensuring that signals transmitted along each of the two branches and recombined at said combination (32) are put into phase opposition,
- means (13, 14) for controlling the phase shift means (2, 3), the switch being characterised in that:
- the phase shift means (2, 3) are composed of the first and second branches (2, 3), the respective lengths of these two branches differing by a quantity substantially equal to an odd number of half-lengths of operating wave of the switch, at least one of the two branches (2; 3; 2, 3) being capable of passing reversibly from a normal state to a super-conducting state at a critical temperature (T_{c}),
- the control means (13, 14) govern the state of one or both of the two branches (2; 3; 2, 3), uniformity and difference of state between the two branches ensuring respectively the opening and closing of the switch, and the impedances of these branches (2, 3) ensuring a division of the power into two portions substantially equal at the location of the branchpoint (23) when the two branches are in the same state.

2. A radio frequency switch according to Claim 1, characterised in that the control means (13, 14) ensure the application of a variable magnetic field to one or both of the two branches, this application causing the critical temperature (T_{c}) of the branch(es) to vary, which ensures the reversible passage from a normal state to a super-conducting state of the branch(es) in question without varying the temperature of the latter.

3. A radio frequency switch according to Claim 2, characterised in that the control means (13, 14) comprise two independent electromagnets (13, 14), the air gaps of which are located respectively around the two branches (2, 3).

4. A radio frequency switch according to Claim 1, characterised in that the control means ensure a variation in the temperature of one or both of the two branches, around the critical temperature (T_{c}), without a variation in the latter.

5. A radio frequency switch according to one of the preceding claims, characterised in that it is open when the two branches (2, 3) are in a normal state.

6. A radio frequency switch according to one of Claims 1 to 4, characterised in that it is open when the two branches (2, 3) are in a super-conducting state.

7. A radio frequency switch according to one of the preceding claims, characterised in that said sections (1, 4) and branches (2, 3) of radio frequency lines are microstrip lines.

8. A radio frequency switch according to one of Claims 1 to 6, characterised in that:
- said sections (1, 4) and branches (2, 3) of radio frequency lines are waveguides;
- said branchpoint (23) and said combination (32) are parallel-T junctions.
